(19) Europäisches Patentamt
European Patent Office
Office européen des brevets

(11) Veröffentlichungsnummer : **0 221 010**
**B1**

(12) # EUROPÄISCHE PATENTSCHRIFT

(45) Veröffentlichungstag der Patentschrift : **26.04.89**

(51) Int. Cl.[4] : **G 03 C 1/68**, C 08 F 2/50

(21) Anmeldenummer : **86810416.7**

(22) Anmeldetag : **17.09.86**

(54) **Photoinitiatorsysteme für radikalisch polymerisierbare Materialien.**

(30) Priorität : **23.09.85 US 779343**

(43) Veröffentlichungstag der Anmeldung : **06.05.87 Patentblatt 87/19**

(45) Bekanntmachung des Hinweises auf die Patenterteilung : **26.04.89 Patentblatt 89/17**

(84) Benannte Vertragsstaaten : **AT BE CH DE FR GB IT LI NL SE**

(56) Entgegenhaltungen : **EP-A- 0 152 377**
**Die Akte enthält technische Angaben, die nach dem Eingang der Anmeldung eingereicht wurden und die nicht in dieser Patentschrift enthalten sind.**

(73) Patentinhaber : **CIBA-GEIGY AG**
**Klybeckstrasse 141**
**CH-4002 Basel (CH)**

(72) Erfinder : **Gatechair, Leslie R.**
**Route 2 Box 60**
**Katonah New York 10536 (US)**
Erfinder : **Blumenstein, Gary M.**
**50 Bullet Hole Road**
**Mahopac New York 10541 (US)**
Erfinder : **Schirmann, Peter J.**
**89 Eunice Avenue**
**Fairfield Connecticut 06430 (US)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Jouve, 18, rue St-Denis, 75001 Paris, France

**Beschreibung**

Die Erfindung betrifft photopolymerisierbare Zusammensetzungen aus einem radikalisch polymerisierbaren Material und einer Kombination von zwei Photoinitiatoren, ein Verfahren zur Photopolymerisation solcher Zusammensetzungen und ein Verfahren zur Erzeugung photographischer Reliefbilder.

Sowohl Photoinitiatoren vom Typ der α-Spalter, wie z. B. Acetophenonderivate oder Benzilketale, als auch Ferroceniumsalz-Photoinitiatoren sind für sich zum Härten verschiedener Beschichtungssysteme verwendet worden. Eine wichtige Anwendung solcher Systeme lag in Bildaufzeichnungsverfahren. So beschreibt z. B. die EP-A-94 914 eine härtbare Zusammensetzung aus einem kationisch polymerisierbaren Material und einem π-Aren-Metallkomplex als Initiator. Diese Zusammensetzung kann entweder direkt durch Erhitzen gehärtet werden oder man aktiviert zuerst den Initiator durch Bestrahlung und härtet dann thermisch. Für eine vollständige Härtung muss jedoch relativ lange belichtet werden, was unwirtschaftlich ist. Eine Erhöhung der Sensitivität des Photoinitiators ist daher wünschenswert. Es wäre ferner wünschenswert, wenn man ohne thermische Behandlung die Härtung allein durch Bestrahlung bewirken könnte.

In der EP-A-109 851 und 152 377 wurde nun gezeigt, dass die Empfindlichkeit bestimmter π-Aren-Metallkomplexe durch Mitverwendung eines Sensibilisators erheblich gesteigert werden kann. In der letzteren Publikation wurde ferner gezeigt, dass die thermische Behandlung weitgehend entbehrt werden kann durch die Mitverwendung eines Oxidationsmittels. Diese kombinierten Initiatorsysteme sind für kationisch polymerisierbare Materialien geeignet, bei der erwähnten Mitverwendung von Oxidationsmitteln können auch radikalisch polymerisierbare Materialien gehärtet werden.

Es wurde nunmehr gefunden, dass radikalische Photohärter, wie z. B. Acetophenonderivate oder Benzilketale in ihrer Photoreaktivität erheblich gesteigert werden können, wenn man bestimmte Ferroceniumsalze zusetzt, obwohl diese Salze für sich allein für radikalische Polymerisationen weitgehend unwirksam sind. Solche kombinierten Systeme stellen daher eine wesentliche Verbesserung der Härtung dar, wie sie als erhöhte Lichtempfindlichkeit gemessen werden kann. Dies gilt für die verschiedensten Materialien, wie sie für Bildaufzeichnung oder andere Anwendungen benutzt werden, in denen eine höhere Empfindlichkeit gegenüber sichtbarem Licht erwünscht ist. Es sei ferner darauf hingewiesen, dass diese überraschende Verbesserung bei der radikalischen Photopolymerisation ohne Zusatz von Oxidationsmitteln erreicht wird.

Die vorliegende Erfindung betrifft eine Zusammensetzung, enthaltend

a) ein radikalisch polymerisierbares Material,

b) mindestens eine Eisenverbindung der Formel I,

$$\left[(R^1)\ (R^2Fe^{II})_a\right]^{+a} \cdot \frac{a}{q}\ [X]^{-q} \qquad (I)$$

worin

a 1 oder 2 ist,

q 1, 2 oder 3 ist,

X Halogen, Nitrat, Sulfat, Phosphat, Perchlorat oder ein komplexes Anion $LQ_m$ bedeutet, worin L ein 2- bis 7-wertiges Metall oder Nichtmetall ist,

Q ein Halogenatom und m eine ganze Zahl ist, die der Summe der Wertigkeit von L und q entspricht,

$R^1$ ein unsubstituiertes oder substituiertes π-Aren bedeutet und

$R^2$ ein unsubstituiertes oder substituiertes Cyclopentadienyl-Anion

bedeutet, gekennzeichnet durch einen Gehalt an

(c) mindestens einem Photoinitiator vom Typ der α-Spalter, wobei die Summe von (b) und (c) 0,05 bis 10 Gew.-% von (a) beträgt und das Gewichtsverhältnis (b) zu (c) 6 : 1 bis 1 : 4 beträgt.

$R^1$ als π-Aren kann ein einkerniges oder mehrkerniges Aren sein. Ein mehrkerniges Aren kann kondensiert oder unkondensiert sein, wobei die Kerne auch über Heteroatome verknüpft sein können. Bevorzugt ist $R^1$ Benzol oder durch einen oder mehrere der Substituenten Halogen, $C_1$-$C_{12}$-Alkyl, $C_2$-$C_{12}$-Alkenyl, $C_2$-$C_{12}$-Alkinyl, $C_1$-$C_8$-Alkoxy, Phenoxy, Cyano, $C_1$-$C_8$-Alkylthio, $C_2$-$C_6$-Alkoxycarbonyl, Phenyl, $C_2$-$C_5$-Alkanoyl oder Benzoyl substituiertes Benzol oder unsubstituiertes oder durch Halogen oder $C_1$-$C_{12}$-Alkyl substituiertes Naphthalin oder Tetrahydronaphthalin.

$R^2$ als substituiertes Cyclopentadienyl-Anion kann mono- oder polysubstituiert sein und die Substituenten können z. B. $C_1$-$C_8$-Alkyl, $C_2$-$C_6$-Alkoxycarbonyl, Cyano, $C_2$-$C_5$-Alkanoyl oder Benzoyl sein.

Die oben erwähnten Alkyl-, Alkoxy-, Alkylthio-, Alkoxycarbonyl- und Alkanoyl-Substituenten können unverzweigt oder verzweigt sein. Beispiele für solche Substituenten sind Methyl, Ethyl, n-Propyl, Isopropyl, n-Butyl, sec.Butyl, tert.Butyl, n-Pentyl, n-Hexyl, n-Octyl ; Methoxy, Ethoxy, n-Propoxy, Isopropoxy, n-Butoxy, n-Hexyloxy, n-Octyloxy ; Methylthio, Ethylthio, n-Propylthio, Isopropylthio, n-Butylthio, n-Pentylthio, n-Hexylthio ; Methoxycarbonyl, Ethoxycarbonyl, n-Propoxycarbonyl, Isopropoxycarbonyl, n-Butoxycarbonyl, n-Pentoxycarbonyl ; Acetyl, Propionyl, Butyryl oder Valeroyl.

Die oben erwähnten Alkyl-, Alkoxy-, Alkylthio- und Alkoxycarbonyl-Gruppen haben vorzugsweise 1-4, insbesondere 1 oder 2 C-Atome im Alkylteil und die oben erwähnten Alkanoylgruppen haben vorzugsweise 2 oder 3 C-Atome.

Wenn $R^1$ ein substituiertes Benzol ist, so enthält es vorzugsweise einen oder zwei der erwähnten Substituenten, insbesondere der Substituenten Chlor, Brom, Methyl, Ethyl, n-Propyl, Isopropyl, Methoxy, Ethoxy, Cyano, Methoxycarbonyl, Ethoxycarbonyl oder Acetyl.

Beispiele von geeigneten $\pi$-Arenen als $R^1$ sind Benzol, Toluol, Xylol, Ethylbenzol, Cumol, Mesitylen, Anisol, Phenetol, Dimethoxybenzol, p-Chlortoluol, Chlorbenzol, Brombenzol, Dichlorbenzol, Acetophenon, Trimethoxybenzol, Dihydronaphthalin, Tetrahydronaphthalin, Methylnaphthalin, Diphenylether, Biphenyl oder Dodecylbenzol. Bevorzugt ist $R^1$ Benzol, Toluol, Xylol, Cumol, Mesitylen, Chlorbenzol, Chlortoluol, Anisol, Dimethoxybenzol, Biphenyl, Diphenylether, Dodecylbenzol, Methylnaphthalin oder Tetrahydronaphthalin.

$R^2$ ist vorzugsweise ein unsubstituiertes oder durch $C_1$-$C_4$-Alkyl substituiertes Cyclopentadienyl-Anion, insbesondere das Cyclopentadienyl- oder Methylcyclopentadienyl-Anion.

In Formel I ist a vorzugsweise 1.

Beispiele für L sind die Elemente Fe, Sn, Br, Al, Ga, In, Ti, Zr, Sc, V, Cr, Mn oder Cu, insbesondere aber B, P, As und Sb. Besonders bevorzugt ist L Phosphor. Q als Halogen ist vorzugsweise Chlor, insbesondere jedoch Fluor.

In Formel I ist q vorzugsweise 1, m vorzugsweise 4 oder 6, Q vorzugsweise Fluor und L vorzugsweise B, P, As oder Sb. Beispiele für komplexe Anionen $[LQ_m]^{-q}$ sind $BF_4^-$, $PF_6^-$, $AsF_6^-$, $SbF_6^-$, $FeCl_4^-$, $SnCl_6^{2-}$, $SbCl_6^-$ oder $BiCl_6^-$. Bevorzugt sind die Anionen $BF_4^-$, $PF_6^-$, $AsF_6^-$ und $SbF_6^-$.

Die Verbindungen der Formel I sind bekannte Verbindungen oder können in Analogie zu den bekannten Verbindungen hergestellt werden.

Die Photoinitiatoren vom Typ der $\alpha$-Spalter wirken bei Photoanregung, d. h. bei Absorption aktinischer Strahlung, unter Bildung eines angeregten Singulett-Zustandes, welcher vermutlich durch innermolekulare Wechselwirkung einen chemisch reaktiven angeregten Triplett-Zustand bildet.

Ohne die Erfindung auf einen solchen Mechanismus beschränken zu wollen, sei als Beispiel hierfür die homolytische C-C-Spaltung aromatischer Carbonylverbindungen genannt, wobei aus dem angeregten Triplett-Zustand heraus ein Zerfall in ein Benzoyl-Radikal und ein Alkyl-Radikal eintreten kann. Diese photolytische $\alpha$-Spaltung ist in der Literatur weitgehend bekannt und wird oft auch als Norrish I-Spaltung bezeichnet.

Zu den Photoinitiatoren, die nach diesem Mechanismus wirken, gehören in erster Linie Carbonylverbindungen, wie z. B. Aroylketale, Benzoin-Derivate, Derivate von $\alpha$-Hydroxy- und $\alpha$-Aminoacetophenon, Ester einer Arylglyoxylsäure oder Acylphosphinoxide, aber auch Verbindungen, die keine Carbonylgruppen enthalten, wie z. B. aromatische Halonium- und Sulfoniumsalze.

Folgende Verbindungsklassen sind besonders geeignet als Komponente (c) :

1) Aroylketale der Formel II,

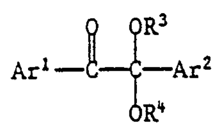

(II)

worin

$Ar^1$ Phenyl oder durch $C_1$-$C_4$-Alkyl oder Halogen substituiertes Phenyl ist,

$Ar^2$ eine der für $Ar^1$ gegebenen Bedeutungen hat oder Wasserstoff, $C_1$-$C_8$-Alkyl oder $C_5$-$C_8$-Cycloalkyl bedeutet,

$R^3$ und $R^4$ unabhängig voneinander $C_1$-$C_6$-Alkyl, $C_3$-$C_4$-Alkenyl, $C_7$-$C_{10}$-Phenylalkyl oder durch Halogen, $C_1$-$C_4$-Alkoxy, $C_2$-$C_8$-Dialkylamino, Morpholino oder Piperidino substituiertes $C_2$-$C_4$-Alkyl bedeuten, oder $R^3$ und $R^4$ zusammen $C_2$-$C_{12}$-Alkandiyl oder 2-Buten-1,4-diyl bedeuten.

Solche Verbindungen sind bekannt aus den US-PS-3 715 293, 3 998 712, 4 485 249 und der GB-PS-1 390 006. Beispiele hierfür sind die folgenden Verbindungen :

2,2-Dimethoxy-1,2-diphenylethanon-1,
2,2-Diethoxy-1,2-diphenylethanon-1,
2,2-Dibutoxy-1,2-diphenylethanon-1,
2,2-Bis-(2-chlorethoxy)-1,2-diphenylethanon-1,
2,2-Bis-(2-morpholinoethoxy)-1,2-diphenylethanon-1,
2,2-Dimethoxy-1,2-di(4-chlorphenyl)-ethanon-1,
2,2-Dimethoxy-1,2-di(4-tolyl)-ethanon-1,
2-Benzoyl-2-phenyl-1,3-dioxolan
2-Benzoyl-4-methyl-2-phenyl-1,3-dioxolan
2-Benzoyl-2-phenyl-1,3-dioxan

2-Benzoyl-2-phenyl-4,7-dihydro-1,3-dioxepin,
2,2-Dimethoxy-1-phenylethanon-1,
2,2-Diethoxy-1-phenylethanon-1,
2,2-Dibutoxy-1-phenylethanon-1,
2,2-Dimethoxy-1-phenylpropanon-1,
2,2-Diethoxy-1-phenylbutanon-1.

2) Benzoin-Derivate der Formel III,

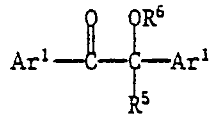

(III)

worin
$Ar^1$ Phenyl oder durch $C_1$-$C_4$-Alkyl oder Halogen substituiertes Phenyl bedeutet,
$R^5$ Wasserstoff, $C_1$-$C_4$-Alkyl, Allyl, Benzyl, Hydroxymethyl oder ($C_1$-$C_4$-Alkoxy)methyl bedeutet,
$R^6$ Wasserstoff, $C_1$-$C_6$-Alkyl, $C_3$-$C_8$-Alkoxyalkyl, Allyl oder Benzyl bedeutet oder $R^5$ und $R^6$ zusammen $—CH_2—O—CH_2—$, $—CH_2—O—C(CH_3)_2—$ oder $—CH_2—O—CH(C_6H_5)—$ bedeuten.

Solche Verbindungen sind z. B. in den DE-PS-1 694 149 und 1 923 266 beschrieben. Beispiele für Verbindungen der Formel III sind :
1,2-Diphenyl-2-methoxyethanon-1,
1,2-Diphenyl-2-ethoxyethanon-1,
1,2-Diphenyl-2-isobutoxyethanon-1,
1,2-Diphenyl-2-methoxypropanon-1,
2,3-Dihydroxy-1,2-diphenylpropanon-1,
2,3-Dimethoxy-1,2-diphenylpropanon-1,
1,2-Di(4-chlorphenyl)-2-isopropoxyethanon-1,
4-Benzoyl-4-phenyl-1,3-dioxolan
4-Benzoyl-2,2-dimethyl-4-phenyl-1,3-dioxolan,
4-Benzoyl-2,4-diphenyl-1,3-dioxolan.

3) Acetophenonderivate der Formel IV,

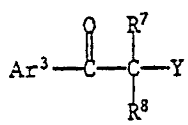

(IV)

worin
$Ar^3$ Phenyl oder durch einen oder mehrere der Reste Halogen, $C_1$-$C_{18}$-Alkyl, $C_3$-$C_{12}$-Alkenyl, $C_1$-$C_{12}$-Alkoxy, $C_1$-$C_{12}$-Alkylthio, $C_1$-$C_{12}$-Alkylamino, $C_2$-$C_{24}$-Dialkylamino, $C_4$-$C_8$-Bis(hydroxyalkyl)-amino, Phenoxy, Phenylthio, 4-Tolylthio, 2-Hydroxyethylthio, Allyloxy, Allylthio, Diallylamino, Bis(2-methoxyethyl)amino, Morpholino, Piperidino oder Pyrrolidino substituiertes Phenyl bedeutet,
$R^7$ und $R^8$ unabhängig voneinander $C_1$-$C_8$-Alkyl oder durch OH, $C_1$-$C_4$-Alkoxy, Benzyloxy, —CN, —COO($C_1$-$C_8$-Alkyl), $C_2$-$C_8$-Dialkylamino oder Morpholino substituiertes $C_1$-$C_4$-Alkyl bedeuten, oder $R_7$ und $R_8$ zusammen $C_2$-$C_9$-Alkandiyl, ($C_1$-$C_4$-Alkoxy)-pentandiyl-1,5, $C_3$-$C_9$-Oxa- oder Azaalkandiyl oder $C_5$-$C_9$-Alkendiyl bedeuten und
Y eine Gruppe $—OR^9$ oder $—NR^{10}R^{11}$ bedeutet, worin $R^9$ Wasserstoff, $C_1$-$C_8$-Alkyl, durch OH, $C_1$-$C_4$-Alkoxy oder CN substituiertes $C_2$-$C_4$-Alkyl, Allyl, Benzyl oder Trimethylsilyl bedeutet oder $R^9$ und $R^7$ zusammen eine Gruppe $—CH_2—O—CH_2—$, $—C(CH_3)_2—O—CH_2—$, $—CH(CH_3)—O—CH_2—$ oder $—CH(C_6H_5)—O—CH_2—$ bedeuten und $R^{10}$ und $R^{11}$ unabhängig voneinander Wasserstoff, $C_1$-$C_{12}$-Alkyl, durch OH, $C_1$-$C_4$-Alkoxy, —CN oder —COO($C_1$-$C_4$-Alkyl) substituiertes $C_2$-$C_4$-Alkyl, Allyl, Benzyl oder Cyclohexyl bedeuten oder $R^{10}$ und $R^{11}$ zusammen $C_3$-$C_7$-Alkandiyl bedeuten, das durch —O— oder $—NR^{12}—$ unterbrochen sein kann, wobei $R^{12}$ Wasserstoff, $C_1$-$C_4$-Alkyl oder $C_2$-$C_4$-Hydroxyalkyl bedeutet.
Solche Verbindungen sind z. B. in der DE-OS-2 722 264 und der EP-A-3002 beschrieben. Beispiele für Verbindungen der Formel IV sind :

2-Hydroxy-2-methyl-1-phenyl-propanon-1,
2-Hydroxy-2-methyl-1-(4-tolyl)-propanon-1,
1-(4-Cumyl)-2-hydroxy-2-methyl-propanon-1,
1-(4-Dodecylphenyl)-2-hydroxy-2-methyl-propanon-1,
1-(3,4-Dimethylphenyl)-2-hydroxy-2-methyl-propanon-1,

1-(4-Chlorphenyl)-2-hydroxy-2-methyl-propanon-1,
2-Hydroxy-1-(4-methoxyphenyl)-2-methyl-propanon-1,
2-Ethyl-2-hydroxy-1-phenyl-hexanon-1,
1-(3-Chlor-4-methylphenyl)-2-hydroxy-2-methyl-propanon-1,
1-(4-Dimethylaminophenyl)-2-hydroxy-2-methyl-propanon-1,
2-Hydroxy-3-methoxy-2-methyl-1-phenylpropanon-1,
2-Methoxy-2-methyl-1-phenyl-propanon-1,
2-Butoxy-2-methyl-1-phenyl-propanon-1,
2-Allyloxy-2-methyl-1-phenyl-propanon-1,
2-Benzyloxy-2-methyl-1-phenyl-propanon-1,
2-Methyl-1-phenyl-2-(trimethylsilyloxy)-propanon-1,
(1-Hydroxycyclohexyl)-phenyl-keton,
(1-Hydroxycyclopentyl)-phenyl-keton,
1-Benzoyl-1-hydroxy-2-methoxycyclohexan,
(1-Hydroxy-3-cyclohexen-1-yl)-phenyl-keton,
2-Dimethylamino-2-methyl-1-phenyl-propanon-1,
2-Methyl-2-morpholino-1-phenyl-propanon-1,
1-(4-Chlorphenyl)-2-methyl-2-morpholino-propanon-1,
2-Methyl-2-morpholino-1-(4-tolyl)-propanon-1,
1-(4-Chlorphenyl)-2-methyl-2-piperidino-propanon-1,
(1-Ethylaminocyclopentyl)-(4-tolyl)-keton,
(1-Dimethylaminocyclohexyl)-phenyl-keton,
2-Dibutylamino-1-(4-chlorphenyl)-2-methyl-propanon-1,
2-Dimethylamino-1-(4-methoxyphenyl)-2-methyl-propanon-1,
1-(4-Methoxyphenyl)-2-methyl-2-morpholino-propanon-1,
2-Bis-(2-methoxyethyl)amino-1-(4-methoxyphenyl)-2-methyl-propanon-1,
2-Methyl-1-(4-methylthiophenyl)-2-morpholino-propanon-1,
2-Ethyl-1-(4-methylthiophenyl)-2-morpholino-hexanon-1,
2-Methyl-1-(4-methylthiophenyl)-2-morpholino-butanon-1,
1-[4-(2-Hydroxyethylthio)phenyl]-2-methyl-2-morpholino-propanon-1,
2-Bis-(2-methoxyethyl)amino-2-methyl-1-(4-methylthiophenyl)-2-morpholino-propanon-1,
1-(4-Butylthiophenyl)-2-methyl-2-morpholino-propanon-1,
2-Dimethylamino-1-(4-dimethylaminophenyl)-2-methyl-propanon-1,
2-Diethylamino-1-(4-diethylaminophenyl)-2-methyl-propanon-1,
2-Methyl-2-morpholino-1-(4-morpholinophenyl)-propanon-1,
2-Ethyl-2-morpholino-1-(4-morpholinophenyl)-hexanon-1,
2-Bis-(2-methoxyethyl)amino-1-(4-morpholinophenyl)-2-methyl-propanon-1,
2-Dimethylamino-2-methyl-1-(4-morpholinophenyl)-propanon-1,
1-(4-Dimethylaminophenyl)-2-methyl-2-morpholino-propanon-1,
4-Benzoyl-2,2,4-trimethyl-1,3-dioxolan.

4) Ester von Arylglyoxylsäuren der Formel V,

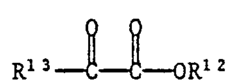
(V)

worin

$R^{12}$ ein unverzweigter oder verzweigter aliphatischer $C_1$-$C_{10}$-Kohlenwasserstoffrest, Phenyl, Benzyl, Cyclohexyl oder Trimethylsilyl ist und

$R^{13}$ $C_6$-$C_{14}$-Aryl oder durch eine oder mehrere der Gruppen Alkyl, Alkoxy, Aryloxy, Alkylthio, Arylthio oder Halogen substituiertes Phenyl bedeutet.

$R^{12}$ als aliphatischer Rest kann z. B. Methyl, Ethyl, Propyl, Butyl, Pentyl, Hexyl, 2-Ethylbutyl, Octyl, 2-Ethylhexyl, Nonyl, Decyl, Allyl oder Methallyl sein.

$R^{13}$ kann z. B. Phenyl, Diphenylyl, Naphthyl, Anthracyl, Tolyl, Xylyl, Methoxyphenyl, Phenoxyphenyl oder Chlorphenyl sein.

Solche Verbindungen sind z. B. in den US-PS-4 038 164 und 4 519 883 beschrieben.

5) Acylphosphinoxide der Formel VI,

RESERVE 5 QG

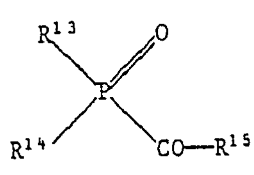
(VI)

worin

$R^{13}$ $C_1$-$C_6$-Alkyl, $C_5$-$C_6$-Cycloalkyl, unsubstituiertes oder durch Halogen, Alkyl oder Alkoxy substituiertes $C_6$-$C_{10}$-Aryl oder ein S oder N enthaltendes 5- oder 6-gliedriger heterocyclischer Rest ist,

$R^{14}$ eine der für $R^{13}$ gegebenen Bedeutungen hat oder $C_1$-$C_6$-Alkoxy, $C_6$-$C_{10}$-Aryloxy oder $C_7$-$C_{10}$-Aralkyloxy ist, oder $R^{13}$ und $R^{14}$ zusammen mit dem P-Atom einen Ring bilden und

$R^{15}$ ein $C_2$-$C_{18}$-Alkylrest, ein $C_2$-$C_4$-Alkenylrest, ein $C_5$-$C_{12}$ cycloaliphatischer Rest, ein durch Alkyl, Alkoxy oder Alkylthio substituierter Phenyl- oder Naphthylrest oder ein S oder N enthaltender 5- oder 6-gliedriger heterocyclischer Rest ist oder eine Gruppe —Z—CO—P(O)($R^{13}$)($R^{14}$) ist, worin Z Phenylen oder $C_2$-$C_6$-Alkylen bedeutet.

Bevorzugt ist $R^{15}$ ein tertiärer $C_4$-$C_{12}$-Alkylrest oder ein aromatischer oder heterocyclischer Rest, der in beiden Orthostellungen zur Bindung an die Carbonylgruppe durch je eine Gruppe Alkyl, Alkoxy, Alkylthio substituiert ist.

Die Verbindungen der Formel IV sind tertiäre Acylphosphinoxide oder Acylphosphinsäure-ester. Sie sind z. B. in den US-PS-4 265 723 und 4 292 152 beschrieben. Beispiele hierfür sind folgende Verbindungen :

Methylester der Isobutyroyl-methyl-phosphinsäure,
Methylester der Isobutyroyl-phenyl-phosphinsäure,
Methylester der Pivaloyl-phenyl-phosphinsäure,
Methylester der 2-Ethylhexanoyl-phenyl-phosphinsäure,
Isopropylester der 2-Ethylhexanoyl-phenyl-phosphinsäure,
Methylester der p-Toluyl-phenyl-phosphinsäure,
Methylester der o-Toluyl-phenyl-phosphinsäure,
Methylester der 2,4-Dimethylbenzoyl-phenyl-phosphinsäure,
Methylester der Acryloyl-benzoyl-phenyl-phosphinsäure,
Isobutyroyl-diphenylphosphinoxid,
2-Ethylhexanoyl-diphenylphosphinoxid,
o-Toluyl-diphenylphosphinoxid,
p-tert.Butylbenzoyl-diphenylphosphinoxid,
3-Pyridylcarbonyl-diphenylphosphinoxid,
Acryloyl-diphenylphosphinoxid,
Benzoyl-diphenylphosphinoxid,
Adipoyl-bis(diphenylphosphinoxid).

6) Aromatische Haloniumsalze der Formel VII,

$$\left[(R^{16})_f(R^{17})_b\mathrm{Hal}\right]_c^+ \qquad \left[MQ_d\right]^{-(d-e)} \qquad \text{(VII)}$$

worin

$R^{16}$ einen einwertigen aromatischen Rest,
$R^{17}$ einen zweiwertigen aromatischen Rest,
Hal ein Halogenatom,
M ein Metall- oder Metalloidatom und
Q ein Halogenatom bedeutet,
f null oder 2 ist,
b null oder 1 ist,
c = d-e ist,
d eine ganze Zahl von 4 bis 8 ist und
e die Wertigkeit von M ist und eine ganze Zahl von 2 bis 7 ist.

$R^{16}$ kann ein Arylrest mit 6-29 C-Atomen sein, der unsubstituiert sein kann oder durch eine oder mehrere der Gruppen $C_1$-$C_8$-Alkyl, $C_1$-$C_8$-Alkoxy, Halogen doer Nitro substituiert sein kann. $R^{16}$ ist vorzugsweise Phenyl, Chlorphenyl, Nitrophenyl, Methoxyphenyl oder Pyridyl.

$R^{17}$ kann z. B. ein Rest der Formel

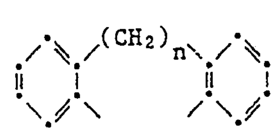

sein worin n 0,1 oder 2 bedeutet.

Hal ist vorzugsweise Iod. Q ist vorzugsweise Fluor oder Chlor. M kann ein Metall sein, wie z. B. Sb, Fe, Sn, Bi, Al, Ga, In, Ti Zr, Sc oder ein Metalloid, wie z. B. B, P oder As.

Beispiele für komplexe Anionen $[MQ_d]^{-(d-e)}$ sind die Anionen $BF_4^-$, $PF_6^-$, $AsF_6^-$, $SbF_6^-$, $FeCl_4^-$, $SnCl_6^{2-}$, $SbCl_6^-$, $BiCl_5^{2-}$, $AlF_6^{3-}$, $GaCl_4^-$, $TiF_6^{2-}$ oder $InF_4^-$.

Beispiele für Verbindungen der Formel VII sind Diphenyliodonium-hexafluorphosphat, p-Methoxyphenyl-phenyliodonium-tetrafluorborat oder Di(p-tolyl)-iodonium-hexafluorarsenat. Solche Verbindungen sind z. B. in den US-PS-4 207 177 und 4 310 469 beschrieben.

7) Aromatische Sulfoniumsalze, wie sie in den US-PS-4 058 401, 4 069 054, 4 173 476 und 4 231 951 beschrieben sind. Beispiele hierfür sind Triphenylsulfonium-tetrafluorborat, Tritolylsulfonium-hexafluorphosphat, Phenacyl-tetramethylensulfonium-hexafluorarsenat, Triphenylsulfonium-hexafluorantimonat oder 4-Phenylthiophenyl-diphenylsulfonium-hexafluorantimonat.

Unter den aufgezählten Verbindungsklassen sind die Klassen 1) bis 3) besonders geeignet als Komponente (c). Unter diesen Verbindungen sind folgende bevorzugt :

1a) Verbindungen der Formel II, worin $Ar^1$ und $Ar^2$ Phenyl sind und $R^3$ und $R^4$ $C_1$-$C_4$-Alkyl sind oder $R^3$ und $R^4$ zusammen Ethandiyl-1,2, Propandiyl-1,2 oder cis-2-Butendiyl-1,4 bedeuten.

1b) Verbindungen der Formel II, worin $Ar^1$ Phenyl ist, $Ar^2$ Wasserstoff ist und $R^3$ und $R^4$ $C_1$-$C_4$-Alkyl sind.

2a) Verbindungen der Formel III, worin $Ar^1$ Phenyl ist, $R^5$ Wasserstoff, Methyl, Hydroxymethyl oder Methoxymethyl bedeutet und $R^6$ Wasserstoff oder $C_1$-$C_6$-Alkyl ist oder $R^5$ und $R^6$ zusammen $-CH_2-O-C(CH_3)_2-$ sind.

3a) Verbindungen der Formel IV, worin

$Ar^3$ Phenyl oder durch Chlor, Methyl, Isopropyl, Dodecyl, Methoxy, Methylthio, Dimethylamino, Diethylamino, Morpholino oder 2-Hydroxyethylthio substituiertes Phenyl bedeutet,

$R^7$ und $R^8$ unabhängig voneinander $C_1$-$C_4$-Alkyl bedeuten oder $R^7$ und $R^8$ zusammen Pentandiyl-1,5 oder $C_5$-$C_7$-Alkendiyl bedeuten,

Y eine Gruppe —OH, Morpholino, Piperidino, 4-Methylpiperazino oder $-NR^{10}R^{11}$ bedeutet, wobei $R^{10}$ und $R^{11}$ $C_1$-$C_4$-Alkyl oder 2-Methoxyethyl bedeuten.

Die Summe der Komponenten (b) und (c) beträgt im allgemeinen 0,05 bis 10 Gew.-% von (a), vorzugsweise 0,2 bis 5 Gew.-%, insbesondere etwa 2 Gew.-%. Das Gewichtsverhältnis von (b) beträgt 6 : 1 bis 1 : 4, bevorzugt ist ein Verhältnis von 2 : 1 bis 1 : 2.

Die Komponente (a) kann aus einer oder mehreren polymerisierbaren Verbindungen bestehen.

Geeignete radikalisch polymerisierbare Materialien sind insbesondere einfach oder mehrfach ethylenisch ungesättigte Verbindungen. Beispiele hierfür sind : Styrol, Vinylpyridin, Vinylacetat, Divinylbenzol, Vinylether, Acrylamid, Methacrylamid, Methylen-bisacrylamid, ungesättigte Polyester, vor allem solche auf Basis von Maleinsäure, sowie Acrylsäurederivate.

Bevorzugte Materialien sind die Ester und Amide von Acryl- und Methacrylsäure. Die Ester können von einwertigen oder mehrwertigen Hydroxylverbindungen abgeleitet sein. Beispiele für einwertige Hydroxylverbindungen sind Methanol, Ethanol, Propanol, Butanol, Pentanol, Hexanol, Octanol, Ethylhexanol, Cyclohexanol, Phenol oder Glycidol. Beispiele von Polyolen sind lineare oder verzweigte Alkandiole, wie z. B. Ethylenglykol, Propylenglykol, Butandiol, Hexandiol oder Octandiol. Weitere Beispiele von Polyolen sind Diethylenglykol, Triethylenglykol, Polyethylenglykole mit einem Molekulargewicht von 200 bis 500, 1,4-Dihydroxycyclohexan, 1,4-Di(hydroxymethyl)cyclohexan, Hydrochinon, Resorcin, 4-(Hydroxymethyl)-phenol, Glycerin, 1,2,4-Trihydroxybutan, Trimethylolpropan, Pentaerythrit, Dipentaerythrit oder niedermolekulare Polyester mit endständigen Hydroxylgruppen. Weitere Polyole sind hydroxylgruppenhaltige Epoxidharz-Prepolymere oder Polyurethan-Prepolymere.

Bevorzugte radikalisch polymerisierbare Materialien sind die Acrylate und Methacrylate von Polyolen, von Epoxidharz-Prepolymeren und von hydroxylgruppenhaltigen Polyurethanen.

Man kann den radikalisch polymerisierbaren Materialien auch kationisch polymerisierbare Materialien zumischen, wie z. B. Epoxide, Melaminharze oder Vinylether. Da das erfindungsgemässe Initiatorsystem auch kationische Polymerisationen initieren kann, verlaufen in diesem Falle radikalische und kationische Härtung nebeneinander oder nacheinander.

Wenn die Komponente (a) flüssig ist, so kann man die Komponenten (b) und (c) in (a) lösen, eventuell unter leichtem Erwärmen, und man erhält homogene flüssige Gemische. Wenn die Komponente (a) fest ist, so kann man sie in einem geeigneten Lösungsmittel lösen oder man schmilzt sie auf, um (b) und (c) darin zu lösen. Man kann natürlich auch (b) und (c) in einem geeigneten Lösungsmittel lösen und diese Lösungen mit dem flüssigen (a) vermischen. Alle diese Mischoperationen geschehen zweckmässig unter rotem oder gelbem Licht.

Die erfindungsgemässen Gemische sind bei Raumtemperatur im Dunkeln oder unter Gelblicht stabil und sind daher lagerfähig. Bei Erwärmung kann Härtung der Gemische eintreten, vor allem bei Temperaturen nahe dem Zersetzungspunkt von (b) und (c).

Die vorliegende Erfindung betrifft daher auch ein Verfahren zur Polymerisation von radikalisch polymerisierbaren Materialien durch Bestrahlung in Gegenwart von (b) mindestens einer Eisenverbindung der Formel I,

$$\left[(R^1)(R^2Fe^{II})_a\right]^{+a} \cdot \frac{a}{q}[X]^{-q} \qquad (I)$$

worin

a 1 oder 2 ist,

q 1, 2 oder 3 ist,

X Halogen, Nitrat, Sulfat, Phosphat, Perchlorat oder ein komplexes Anion $LQ_m$ bedeutet, worin L ein 2- bis 7-wertiges Metall oder Nichtmetall ist,

Q ein Halogenatom und m eine ganze Zahl ist, die der Summe der Wertigkeit von L und q entspricht,

$R^1$ ein unsubstituiertes oder substituiertes $\pi$-Aren bedeutet und

$R^2$ ein unsubstituiertes oder substituiertes Cyclopentadienyl-Anion bedeutet, gekennzeichnet durch die Gegenwart von (c) mindestens einem Photoinitiator vom Typ der $\alpha$-Spalter, wobei die Summe von (b) und (c) 0,05 bis 10 Gew.- % des radikalisch polymerisierbaren Materials beträgt und das Gewichtsverhältnis (b) zu (c) 6 : 1 bis 1 : 4 beträgt.

Die zu härtenden Zusammensetzungen, die man auch Photopolymere nennt, werden mit Elektronenstrahlen oder mit aktinischem Licht bestrahlt, vorzugsweise mit Licht von der Wellenlänge 200-600 nm. Strahlenquellen, die hierfür gebräuchlich sind, sind z. B. Xenonlampen, Argonlampen, Wolframlampen, Kohlebogenlampen, Metallhalogenidlampen und Metall-Lichtbogenlampen, wie z. B. Quecksilber-, Niederdruck-, Mitteldruck- oder Hochdrucklampen. Bevorzugt verwendet man Metallhalogenidlampen oder Quecksilber-Hochdrucklampen. Auch Bestrahlung mit Sonnenlicht oder Fluoreszenzlampen ist möglich. Die Bestrahlungszeit hängt von verschiedenen Faktoren ab, z. B. von der Art des zu härtenden Materials, von der Art der Strahlenquelle und deren Leistung und ihre Entfernung vom Material. Die heute üblichen Bestrahlungsanlagen haben Leistungen von 150 bis 5 000 Watt. Mit solchen Lampen genügen meist Bestrahlungszeiten von 10 bis 60 Sekunden.

Die belichteten Materialien können thermisch nachbehandelt werden um eine stärkere Vernetzung des Polymeren zu erzielen. Dies kann z. B. in üblichen Umluftöfen geschehen oder durch Infrarotbestrahlung oder Mikrowellenheizung.

Die erfindungsgemässen Zusammensetzungen können noch andere Zusätze enthalten, wie sie in der Technologie photopolymerisierbarer Materialien üblich sind. Beispiele hierfür sind Pigmente, Farbstoffe, Füllstoffe, Verstärkungsmittel, Flammschutzmittel, Antistatica, Verlaufhilfsmittel, Antioxidantien oder Lichtschutzmittel.

Um die Lagerstabilität der Zusammensetzungen zu erhöhen, kann man schwache organische Basen zusetzen, wie z. B. Nitrile, Amide, Lactame oder Harnstoffderivate. Um vorzeitige Härtung durch unbeabsichtigten Lichtzutritt zu vermeiden, können kleine Mengen an UV-Absorbern und/oder organischen Farbstoffen zugesetzt werden.

Die erfindungsgemässen Zusammensetzungen können nach üblichen Methoden auf die Substrate aufgebracht werden. Geeignete Substrate sind z. B. Metalle, Siliziumscheiben, keramische Massen, Glas, Kunststoffe, Papier oder Holz. Das aufgebrachte Material bildet nach der Härtung eine schützende und passivierende Schicht auf dem Substrat.

Wenn bei der Belichtung nur ein Teil der Schicht durch eine Photomaske belichtet wird, so können die unbelichteten Stellen anschliessend mit einem geeigneten Lösungsmittel entfernt werden. Im Falle eines flüssigen Photopolymers können die unbelichteten Anteile mit Heissluft weggeblasen werden. Das so erhaltene Reliefbild kann durch eine weitere Belichtung oder durch Wärmebehandlung nachgehärtet werden. Auf diese Weise ist das beschichtete Material auch als photographisches Aufzeichnungsmaterial verwendbar und kann z. B. zur Herstellung von Druckplatten und von gedruckten Schaltungen gebraucht werden oder als Lötresist, Photoresist oder Aetzresist. Die Verwendung zur Erzeugung von photographischen Reliefbildern ist ebenfalls Gegenstand der Erfindung.

Die erfindungsgemässen Photoinitiator-Mischungen erhöhen die Lichtempfindlichkeit solcher Abbildungssysteme, ohne dass die Menge am Photoinitiator erhöht werden muss, was für solche Anwendungen ein erheblicher Vorteil ist. Die UV-Strahlen dringen tiefer in die Schicht ein, wodurch bessere Durchhärtung und damit höhere optische Auflösung erzielt werden.

Die folgende Prozedur ist eine allgemeine Anleitung zur Herstellung von Druckplatten mit den erfindungsgemässen Zusammensetzungen.

Auf ein schwarz gestrichenes Aluminiumblech wird die Mischung aus dem Photopolymer und den beiden Photoinitiatoren in etwa 1 mm Schichtdicke aufgetragen. Dann wird eine erste Belichtung durchgeführt, die den Zweck hat, die Viskosität zu erhöhen und damit den Sauerstoffgehalt zu verringern, wodurch die Empfindlichkeit des Photopolymers erhöht wird. Bei industriellen Verfahren geschieht diese Vorbelichtung meist mit einer Quecksilber-Niederdrucklampe, beispielsweise einem sogenannten Schwarzlichtstrahler. Das Photonegativ, das auf einer Glasplatte fixiert ist, wird bis auf einen Abstand von etwa 0,5 mm an das Photopolymer herangebracht. Dann erfolgt die Hauptbelichtung, beispielsweise mit einer Xenonlampe, für etwa 35-55 Sekunden. Bei dieser Belichtung hat das Photopolymer an den belichteten Stellen eine Härtung in den tieferen Schichten erfahren. An der Oberfläche ist keine Härtung erfolgt. Die überstehende Flüssigkeit sowie das nicht belichtete Polymer wird mit einem Heissluftstrom

hoher Strömungsgeschwindigkeit weggeblasen und kann wieder zur Beschichtung neuer Platten verwendet werden. Dann wird die Platte mit weichem Löschpapier getrocknet und schliesslich unter einer Hochleistungslampe nachgehärtet.

Weitere Illustrationen der Erfindung geben die folgenden Beispiele. Darin bedeuten Teile Gewichtsteile, wenn nicht anders angegeben. Die folgenden Photoinitiatoren werden darin verwendet :

A = ($\eta^6$-Isopropylbenzol) ($\eta^5$-cyclopentadienyl)eisen(II)-hexafluorphosphat
B = 2,2-Dimethoxy-1,2-diphenylethanon-1
C = 2,2-Diethoxy-1,2-diphenylethanon-1
D = 2,2-Dimethyl-2-hydroxyacetophenon
E = 1-Hydroxycyclohexyl-phenyl-keton

Beispiel 1

Die in der Tabelle angegebenen Mengen an Photoinitiatoren werden in verschiedenen radikalisch polymerisierbaren Materialien gelöst und die Lösung in einer Stärke von 1,25 mm auf nicht-reflektierendes schwarzes Papier aufgetragen. Im Abstand von 0,5 mm über der Beschichtung sind ein Stufenkeil mit 50 Stufen verschiedener optischer Durchlässigkeit montiert. Die Proben werden durch dieses Negativ mit einer stationären Quecksilberlampe belichtet, wobei eine Energie von 160 mJ/cm$^2$ ausgestrahlt wird. Dann bestimmt man die höchste Stufe des Stufenkeils, unter der sich gerade eine Haut des Polymeren gebildet hat. Diese Stufenzahl ist ein gutes Kriterium für die relative Empfindlichkeit (Photosensitivität) der Formulierung. Je höher die Stufenzahl, desto empfindlicher ist die Formulierung.

Tabelle 1

| Photoinitiator in Gew.-% | Relative Empfindlichkeit (Stufenzahl) Photopolymerisierbares Material | | | |
|---|---|---|---|---|
| | 1 | 2 | 3 | 4 |
| 1 % A | 6,5 | 6 | 6 | 15 |
| 1 % B | 7,5 | 10 | 6 | 9 |
| 2 % B | 9,0 | 13 | 10 | 13 |
| 1 % A + 1 % B | 13,0 | 15 | 14 | 24 |
| 1 % A + 2 % B | - | G | 18 | 22 |
| 2 % A + 1 % B | 16,5 | G | 14 | 27 |
| 3 % A + 1 % B | 17,0 | G | G | G |

1 = Epoxyacrylat (Cellrad® 6700, Celanese Plastics & Specialities)
2 = Polyurethanacrylat (Uvetan® 893, Morton Thiokol)
3 = Polyurethanacrylat (Cargill® 1512, Cargill Inc.)
4 = Polyurethanacrylat (Cargill® 1522, Cargill Inc.)
G = Gelbildung vor dem Test durch Lagerung in brauner Glasflasche unter dem Licht von Leuchtstoffröhren.

Diese Ergebnisse zeigen die Steigerung der Empfindlichkeit bei Kombination beider Photoinitiatoren. Die hohe Photosensitivität der Proben zeigt sich auch in der vorzeitigen Gelbildung bei der Lagerung in braunen Flaschen.

Beispiel 2

Ein Methacrylat-modifiziertes Polyurethan mit den in der Tabelle angegebenen Photoinitiatoren wird auf ein nicht-reflektierendes schwarzes Papier in einer Schichtdicke von 1,25 mm aufgebracht. Ein auf eine Glasplatte aufgebrachter 50 Stufen-Keil wird im Abstand von 0,4 mm über der Beschichtung montiert. Mit einer 5 kW-Quecksilber-Hochdrucklampe werden die Proben mit einer Energiemenge von 160 mJ/cm$^2$ belichtet. Wie in Beispiel 1 beschrieben, wird die höchste Stufe, bei der sich gerade eine Haut des Polymeren gebildet hat bestimmt und dient als Mass für die Photosensitivität. Die Ergebnisse sind in Tabelle 2 aufgeführt.

Tabelle 2

| Photoinitiator | Relative Photosensitivität (Max. Stufenzahl) |
|---|---|
| 1 % A | 0 |
| 1 % B | 19 |
| 1 % A + 1 % B | 22 |
| 1 % C | 16 |
| 1 % A + 1 % C | 20 |
| 1 % D | 5 |
| 1 % A + 1 % D | 15 |

Beispiel 3

In diesem Beispiel wird die Herstellung von Druckplatten simuliert. Als photopolymerisierbares Material wird ein aliphatisches Polyurethan-methacrylat verwendet, dem verschiedene Mengen der Photoinitiatoren A und B zugesetzt werden.

Das Photopolymer wird erst ohne Maske mit einer Xenonbogenlampe kurz vorbelichtet. Die Hauptbelichtung erfolgt durch eine Negativ-Folie (Fa. Gammatrol), die neben einem Strichmuster eine halbkreisförmige Skala von Halbton-Punktrastern mit 27 Abstufungen aufweist. Stufe 27 hat die grössten Rasterpunkte, Stufe 1 die kleinsten, entsprechend dem feinsten Raster auf der Druckplatte. Rasterstufe 15-20 stellt die Grautöne auf dem Druckbild dar. Gemessen wird der feinste Raster, der auf der Druckplatte noch abgebildet wird.

Wenn Stufe 2 oder 3 der Gammatrol-Skala noch abgebildet sind, so ist der Test erfüllt, d. h. das Photopolymer hat eine akzeptable Empfindlichkeit.

Die feinen Rasterpunkte verschwinden, wenn ihre Form nicht voll ausgeprägt ist und z. B. runde Schultern hat. Oder die Rasterpunkte haben Pilzform und verschwinden bei der Entwicklung.

Tabelle 3 zeigt die Ergebnisse der Variation des Photoinitiators und der Belichtungszeiten.

Tabelle 3

| Photoinitiator | Vorbelichtung (Sekunden) | Hauptbelichtung (Sekunden) | Rasterabbildung (Gammatrol-Skala) |
|---|---|---|---|
| 1 % A | 1,5 | 55 | keine Durchhärtung |
| 1 % B | 0,5 | 55 | 8 |
| 2 % B | 0,2 | 45 | 15 |
| 1 % A + 1 % B | 0,2 | 55 | 1 |
| 1 % A + 1 % B | 0,2 | 45 | 1 |
| 1 % A + 1 % B | 0,2 | 35 | 2 |
| 1 % A + 1 % B | 0 | 35 | 8 |
| 0,5 % A + 0,5 % B | 1,0 | 55 | 5 |
| 0,1 % A + 0,5 % B | 0,8 | 55 | 2-3 |

Beispiel 4

Ein Photopolymer wird bereitet durch Vermischen der folgenden Komponenten :

80 Teile eines wasserdispergierbaren Polyurethanacrylates (Chempol® 19-4867, Radcure Specialities Inc.)

15 Teile Polyethylenglykol-dimethacrylat

5 Teile N-Vinylpyrrolidon

Dazu werden die in Tabelle 4 angegebenen Photoinitiatoren zugegeben. Die Proben werden wie in Beispiel 2 beschrieben auf schwarzes Papier aufgebracht und durch eine 50-Stufen Negativ-Maske belichtet mit einer Strahlungsenergie von 442 mJ/cm$^2$. Die Beurteilung der relativen Photosensitivität geschieht wie in Beispiel 2. Als $\alpha$-Spalter wird 1-Hydroxycyclohexylphenyl-keton (E) verwendet. Die Resultate sind in Tabelle 4 aufgeführt.

Tabelle 4

| Photoinitiator | Rel. Photosensitivität (Max. Stufenzahl |
|---|---|
| Keiner | 0 |
| 1 % A | 3 |
| 1 % E | 5 |
| 0,2 % A + 1 % E | 10 |
| 1 % A + 1 % E | 15 |
| 2 % A + 2 % E | 20 |

**Patentansprüche**

1. Photopolymerisierbare Zusammensetzung enthaltend
a) ein radikalisch polymerisierbares Material,
b) mindestens eine Eisenverbindung der Formel I,

$$\left[(R^1)(R^2Fe^{II})_a\right]^{+a} \cdot \frac{a}{q}[X]^{-q} \qquad (I)$$

worin
a 1 oder 2 ist,
q 1, 2 oder 3 ist,
X Halogen, Nitrat, Sulfat, Phosphat, Perchlorat oder [$LQ_m$] bedeutet, worin
L ein 2-7-wertiges Metall oder Nichtmetall ist,
Q ein Halogenatom ist und
m eine ganze Zahl ist, die der Summe der Wertigkeit von L und q entspricht,
$R^1$ ein unsubstituiertes oder substituiertes $\pi$-Aren bedeutet und
$R^2$ ein unsubstituiertes oder substituiertes Cyclopentadienyl-Anion
bedeutet, gekennzeichnet durch einen Gehalt an
c) mindestens einem Photoinitiator vom Typ der $\alpha$-Spalter, wobei die Summe von (b) und (c) 0,05 bis 10 Gew.-% von (a) beträgt und das Gewichtsverhältnis von (b) zu (c) 6 : 1 bis 1 : 4 beträgt.

2. Zusammensetzung gemäss Anspruch 1, worin die Summe von (b) und (c) 0,2 bis 5 Gew.-% von (a) beträgt und das Gewichtsverhältnis von (b) zu (c) 2 : 1 bis 1 : 2 beträgt.

3. Zusammensetzung gemäss Anspruch 1, enthaltend als Komponente (b) eine Verbindung der Formel I, worin $R^1$ Benzol oder durch einen oder mehrere der Substituenten Halogen, $C_1$-$C_{12}$-Alkyl, $C_2$-$C_{12}$-Alkenyl, $C_2$-$C_{12}$-Alkinyl, $C_1$-$C_8$-Alkoxy, Phenoxy, Cyano, $C_1$-$C_8$-Alkylthio, $C_2$-$C_6$-Alkoxycarbonyl, Phenyl, $C_2$-$C_5$-Alkanoyl oder Benzoyl substituiertes Benzol oder unsubstituiertes oder durch Halogen oder $C_1$-$C_{12}$-Alkyl substituiertes Naphthalin oder Tetrahydronaphthalin bedeutet.

4. Zusammensetzung gemäss Anspruch 3, worin $R^1$ Benzol, Toluol, Xylol, Cumol, Mesitylen, Chlorbenzol, Chlortoluol, Anisol, Dimethoxybenzol, Biphenyl, Diphenylether, Dodecylbenzol, Methylnaphthalin oder Tetrahydronaphthalin ist.

5. Zusammensetzung gemäss Anspruch 1, enthaltend als Komponente (b) eine Verbindung der

Formel I, worin $R^2$ ein Cyclopentadienyl-Anion ist, das unsubstituiert oder durch einen oder mehrere der Substituenten $C_1$-$C_8$-Alkyl, $C_2$-$C_6$-Alkoxycarbonyl, Cyano, $C_2$-$C_5$-Alkanoyl oder Benzoyl substituiert ist.

6. Zusammensetzung gemäss Anspruch 5, worin $R^2$ ein Cyclopentadienyl- oder Methylcyclopentadienyl-Anion ist.

7. Zusammensetzung gemäss Anspruch 1, enthaltend als Komponente (b) eine Verbindung der Formel I, worin a = 1 ist, q = 1 ist, und X ein komplexes Anion $LQ_m$ bedeutet, worin L Bor, Phosphor, Arsen oder Antimon ist, m = 4 oder 6 ist und Q Fluor ist.

8. Zusammensetzung gemäss Anspruch 1, worin die Komponente (b) ($\eta^6$-Isopropylbenzol) ($\eta^6$-cyclopentadienyl)eisen(II)-hexafluorphosphat ist.

9. Zusammensetzung gemäss Anspruch 1, worin die Komponente (c) ein Aroylketal, ein Benzoin-Derivat, ein Derivat von $\alpha$-Hydroxy- oder $\alpha$-Aminoacetophenon, ein Ester einer Arylglyoxylsäure, ein Acylphosphinoxid, ein aromatisches Haloniumsalz oder ein aromatisches Sulfoniumsalz ist.

10. Zusammensetzung gemäss Anspruch 1, worin die Komponente (c) eine Verbindung der Formel II ist,

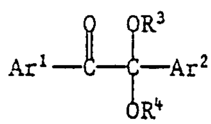 (II)

worin

$Ar^1$ Phenyl oder durch $C_1$-$C_4$-Alkyl oder Halogen substituiertes Phenyl ist,

$Ar^2$ eine der für $Ar^1$ gegebenen Bedeutungen hat oder Wasserstoff, $C_1$-$C_8$-Alkyl oder $C_5$-$C_8$-Cycloalkyl bedeutet,

$R^3$ und $R^4$ unabhängig voneinander $C_1$-$C_6$-Alkyl, $C_3$-$C_4$-Alkenyl, $C_7$-$C_{10}$-Phenylalkyl oder durch Halogen, $C_1$-$C_4$-Alkoxy, $C_2$-$C_8$-Dialkylamino, Morpholino oder Piperidino substituiertes $C_2$-$C_4$-Alkyl bedeuten, oder $R^3$ und $R^4$ zusammen $C_2$-$C_{12}$-Alkandiyl oder 2-Buten-1,4-diyl bedeuten.

11. Zusammensetzung gemäss Anspruch 1, worin die Komponente (c) eine Verbindung der Formel III ist,

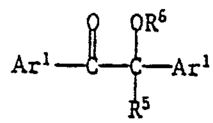 (III)

worin

$Ar^1$ Phenyl oder durch $C_1$-$C_4$-Alkyl oder Halogen substituiertes Phenyl bedeutet,

$R^5$ Wasserstoff, $C_1$-$C_4$-Alkyl, Allyl, Benzyl, Hydroxymethyl oder ($C_1$-$C_4$-Alkoxy)methyl bedeutet,

$R^6$ Wasserstoff, $C_1$-$C_6$-Alkyl, $C_3$-$C_8$-Alkoxyalkyl, Allyl oder Benzyl bedeutet oder $R^5$ und $R^6$ zusammen $—CH_2—O—CH_2—$, $—CH_2—O—C(CH_3)_2—$ oder $—CH_2—O—CH(C_6H_5)—$ bedeuten.

12. Zusammensetzung gemäss Anspruch 1, worin die Komponente (c) eine Verbindung der Formel IV ist,

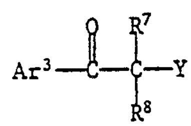 (IV)

worin

$Ar^3$ Phenyl oder durch einen oder mehrere der Reste Halogen, $C_1$-$C_{18}$-Alkyl, $C_3$-$C_{12}$-Alkenyl, $C_1$-$C_{12}$-Alkoxy, $C_1$-$C_{12}$-Alkylthio, $C_1$-$C_{12}$-Alkylamino, $C_2$-$C_{24}$-Dialkylamino, $C_4$-$C_8$-Bis(hydroxyalkyl)-amino, Phenoxy, Phenylthio, 4-Tolylthio, 2-Hydroxyethylthio, Allyloxy, Allylthio, Diallylamino, Bis(2-methoxyethyl)amino, Morpholino, Piperidino oder Pyrrolidino substituiertes Phenyl bedeutet,

$R^7$ und $R^8$ unabhängig voneinander $C_1$-$C_8$-Alkyl oder durch OH, $C_1$-$C_4$-Alkoxy, Benzyloxy, —CN, —COO($C_1$-$C_8$-Alkyl), $C_2$-$C_8$-Dialkylamino oder Morpholino substituiertes $C_1$-$C_4$-Alkyl bedeuten, oder $R^7$ und $R^8$ zusammen $C_2$-$C_9$-Alkandiyl, ($C_1$-$C_4$-Alkoxy)-pentandiyl-1,5, $C_3$-$C_9$-Oxa- oder Azaalkandiyl oder $C_5$-$C_9$-Alkendiyl bedeuten und

Y eine Gruppe $—OR^9$ oder $—NR^{10}R^{11}$ bedeutet, worin $R^9$ Wasserstoff, $C_1$-$C_8$-Alkyl, durch OH, $C_1$-$C_4$-Alkoxy oder CN substituiertes $C_2$-$C_4$-Alkyl, Allyl, Benzyl oder Trimethylsilyl bedeutet oder $R^9$ und $R^7$ zusammen eine Gruppe $—CH_2—O—CH_2—$, $—C(CH_3)_2—O—CH_2—$, $—CH(CH_3)—O—CH_2—$ oder $—CH(C_6H_5)—O—CH_2—$ bedeuten und $R^{10}$ und $R^{11}$ unabhängig voneinander Wasserstoff, $C_1$-$C_{12}$-Alkyl, durch OH, $C_1$-$C_4$-Alkoxy, —CN oder —COO($C_1$-$C_4$-Alkyl) substituiertes $C_2$-$C_4$-Alkyl, Allyl, Benzyl oder Cyclohexyl bedeuten oder $R^{10}$ und $R^{11}$ zusammen $C_3$-$C_7$-Alkandiyl bedeuten, das durch —O— oder $—NR^{12}—$ unterbrochen sein kann, wobei $R^{12}$ Wasserstoff, $C_1$-$C_4$-Alkyl oder $C_2$-$C_4$-Hydroxyalkyl bedeutet.

13. Zusammensetzung gemäss Anspruch 12, wobei in Formel IV

$Ar^3$ Phenyl oder durch Chlor, Methyl, Isopropyl, Dodecyl, Methoxy, Methylthio, Dimethylamino, Diethylamino, Morpholino oder 2-Hydroxyethylthio substituiertes Phenyl bedeutet,

$R^7$ und $R^8$ unabhängig voneinander $C_1$-$C_4$-Alkyl bedeuten oder $R^7$ und $R^8$ zusammen Pentandiyl-1,5 oder $C_5$-$C_7$-Alkendiyl bedeuten, und

Y eine Gruppe —OH, Morpholino, Piperidino, 4-Methylpiperazino oder $-NR^{10}R^{11}$ bedeutet, wobei $R^{10}$ und $R^{11}$ $C_1$-$C_4$-Alkyl oder 2-Methoxyethyl bedeuten.

14. Zusammensetzung gemäss Anspruch 1, worin die Komponente (a) aus einer oder mehreren einfach oder mehrfach ethylenisch ungesättigten Verbindungen besteht.

15. Zusammensetzung gemäss Anspruch 14, worin (c) ein Acrylat oder Methacrylat eines Polyols, eines Epoxidharz-Prepolymeren oder eines hydroxylgruppenhaltigen Polyurethans enthält.

16. Verfahren zur Polymerisation von radikalisch polymerisierbaren Materialien durch Bestrahlung in Gegenwart von (b) mindestens einer Eisenverbindung der Formel I,

$$\left[(R^1)\ (R^2Fe^{II})_a\right]^{+a} \quad \cdot \quad \frac{a}{q}\ [X]^{-q} \qquad (I)$$

worin

a 1 oder 2 ist,

q 1, 2 oder 3 ist,

X Halogen, Nitrat, Sulfat, Phosphat, Perchlorat oder ein komplexes Anion $LQ_m$ bedeutet, worin L ein 2- bis 7-wertiges Metall oder Nichtmetall ist,

Q ein Halogenatom und m eine ganze Zahl ist, die der Summe der Wertigkeit von L und q entspricht,

$R^1$ ein unsubstituiertes oder substituiertes $\pi$-Aren bedeutet und

$R^2$ ein unsubstituiertes oder substituiertes Cyclopentadienyl-Anion bedeutet, gekennzeichnet durch die Gegenwart von (c) mindestens einem Photoinitiator vom Typ der $\alpha$-Spalter, wobei die Summe von (b) und (c) 0,05 bis 10 Gew.-% des radikalisch polymerisierbaren Materials beträgt und das Gewichtsverhältnis (b) zu (c) 6 : 1 bis 1 : 4 beträgt.

17. Verfahren gemäss Anspruch 18, dadurch gekennzeichnet, dass man mit Licht von der Wellenlänge 200-600 nm bestrahlt.

18. Verfahren zur photographischen Erzeugung eines Reliefbildes, dadurch gekennzeichnet, dass man eine Zusammensetzung gemäss Anspruch 1 auf ein Trägermaterial aufbringt, durch eine Photomaske nach dem Verfahren des Anspruch 16 belichtet und anschliessend das unbelichtete Material der Zusammensetzung entfernt.

19. Verfahren gemäss Anspruch 18, dadurch gekennzeichnet, dass man nach Entfernung des unbelichteten Materials das belichtete Material durch eine weitere Belichtung oder durch Wärmebehandlung nachhärtet.

**Claims**

1. A photopolymerizable composition containing

a) a material polymerizable by free radical polymerization,

b) at least one iron compound of the formula I

$$\left[(R^1)\ (R^2Fe^{II})_a\right]^{+a} \quad \cdot \quad \frac{a}{q}\ [X]^{-q} \qquad (I)$$

in which

a is 1 or 2,

q is 1, 2 or 3,

X is halogen, nitrate, sulfate, phosphate, perchlorate or $[LQ_m]$, in which

L is a divalent to heptavalent metal or non-metal,

Q is a halogen atom and

m is an integer corresponding to the sum of the valency of L and q,

$R^1$ is an unsubstituted or substituted $\pi$-arene, and

$R^2$ is an unsubstituted or substituted cyclopentadienyl anion,

characterized by a content of

c) at least one $\alpha$-cleavage photoinitiator, the sum of (b) and (c) being from 0.05 to 10 %, by weight of (a) and the weight ratio of (b) to (c) being from 6 : 1 to 1 : 4.

2. The composition according to claim 1, in which the sum of (b) and (c) is from 0.2 to 5 %, by weight of (a) and the weight ratio of (b) to (c) is from 2 : 1 to 1 : 2.

3. The composition according to claim 1, containing as component (b) a compound of the formula I

in which $R^1$ is benzene or benzene substituted by one or more of the substituents halogen, $C_1$-$C_{12}$alkyl, $C_2$-$C_{12}$alkenyl, $C_2$-$C_{12}$alkynyl, $C_1$-$C_8$alkoxy, phenoxy, cyano, $C_1$-$C_8$alkylthio, $C_2$-$C_6$-alkoxycarbonyl, phenyl, $C_2$-$C_5$alkanoyl or benzoyl, or $R^1$ is naphthalene which is unsubstituted or substituted by halogen or by $C_1$-$C_{12}$alkyl or $R^1$ is tetrahydronaphthalene.

4. The composition according to claim 3, in which $R^1$ is benzene, toluene, xylene, cumene, mesitylene, chlorobenzene, chlorotoluene, anisole, dimethoxybenzene, biphenyl, diphenyl ether, dodecylbenzene, methylnaphthalene or tetrahydronaphthalene.

5. The composition according to claim 1, containing as component (b) a compound of the formula I in which $R^2$ is a cyclopentadienyl anion which is unsubstituted or substituted by one or more of the substituents $C_1$-$C_8$-alkyl, $C_2$-$C_6$alkoxycarbonyl, cyano, $C_2$-$C_5$alkanoyl or benzoyl.

6. The composition according to claim 5, in which $R^2$ is a cyclopentadienyl or methylcyclopentadienyl anion.

7. The composition according to claim 1, containing as component (b) a compound of the formula I in which a is 1, q is 1 and X is a complex anion $LQ_m$ in which L is boron, phosphorus, arsenic or antimony, m is 4 or 6 and Q is fluorine.

8. The composition according to claim 1, in which the component (b) is ($\eta^6$-isopropylbenzene)-($\eta^6$-cyclopentadienyl)-iron (II) hexafluorophosphate.

9. The composition according to claim 1, in which component (c) is an aroylketal, a benzoin derivative, a derivative of α-hydroxyacetophenone or α-aminoacetophenone, an ester of arylglyoxylic acid, an acylphosphine oxide, an aromatic halonium salt or an aromatic sulfonium salt.

10. The composition according to claim 1, in which the component (c) is a compound of the formula II

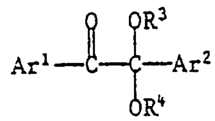

(II)

in which

$Ar^1$ is phenyl or phenyl substituted by $C_1$-$C_4$alkyl or halogen,

$Ar^2$ has one of the meanings assigned to $Ar^1$ or is hydrogen, $C_1$-$C_8$-alkyl or $C_5$-$C_8$cycloalkyl,

$R^3$ and $R^4$ independently of one another are $C_1$-$C_6$alkyl, $C_3$-$C_4$-alkenyl, $C_7$-$C_{10}$phenylalkyl or $C_2$-$C_4$alkyl substituted by halogen, $C_1$-$C_4$alkoxy, $C_2$-$C_8$dialkylamino, morpholino or piperidino, or $R^3$ and $R^4$ are together $C_2$-$C_{12}$alkanediyl or 2-butene-1,4-diyl.

11. The composition according to claim 1, in which the component (c) is a compound of the formula III

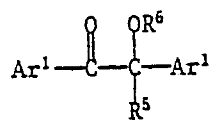

(III)

in which

$Ar^1$ is phenyl or phenyl substituted by $C_1$-$C_4$alkyl or halogen,

$R^5$ is hydrogen, $C_1$-$C_4$alkyl, allyl, benzyl, hydroxymethyl or ($C_1$-$C_4$-alkoxy)-methyl,

$R_6$ is hydrogen, $C_1$-$C_6$alkyl, $C_3$-$C_8$alkoxyalkyl, allyl or benzyl or $R^5$ and $R^6$ together are $-CH_2-O-CH_2-$, $-CH_2-O-C(CH_3)_2-$ or $-CH_2-O-CH(C_6H_5)-$.

12. The composition according to claim 1, in which the component (c) is a compound of the formula IV

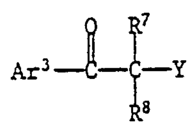

(IV)

in which

$Ar^3$ is phenyl or phenyl substituted by one or more of the radicals halogen, $C_1$-$C_{18}$alkyl, $C_3$-$C_{12}$alkenyl, $C_1$-$C_{12}$alkoxy, $C_1$-$C_{12}$alkylthio, $C_1$-$C_{12}$alkylamino, $C_2$-$C_{24}$dialkylamino, $C_4$-$C_8$bis(hydroxyalkyl)-amino, phenoxy, phenylthio, 4-tolylthio, 2-hydroxyethylthio, allyloxy, allylthio, diallylamino, bis(2-methoxyethyl)-amino, morpholino, piperidino or pyrrolidino,

$R^7$ and $R^8$ independently of one another are $C_1$-$C_8$alkyl or $C_1$-$C_4$alkyl substituted by OH, $C_1$-$C_4$alkoxy, benzyloxy, —CN, —COO($C_1$-$C_8$alkyl), $C_2$-$C_8$dialkylamino or morpholino, or $R^7$ and $R^8$ together are $C_2$-$C_9$alkanediyl, ($C_1$-$C_4$alkoxy)-pentane-1,5-diyl, $C_3$-$C_9$oxa or azaalkanediyl or $C_5$-$C_9$alkenediyl and

Y is a group $-OR^9$ or $-NR^{10}R^{11}$, in which $R^9$ is hydrogen, $C_1$-$C_8$alkyl, $C_2$-$C_4$-alkyl substituted by OH, $C_1$-$C_4$alkoxy or CN, or is allyl, benzyl or trimethylsilyl, or $R^9$ and $R^7$ together are a group

$-CH_2-O-CH_2-$, $-C(CH_3)_2-O-CH_2-$, $-CH(CH_3)-O-CH_2$ or $-CH(C_6H_5)-O-CH_2-$ and $R^{10}$ and $R^{11}$ independently of one another are hydrogen, $C_1$-$C_{12}$alkyl, $C_2$-$C_4$alkyl substituted by OH, $C_1$-$C_4$alkoxy, —CN or —COO($C_1$-$C_4$alkyl), or are allyl, benzyl or cyclohexyl, or $R^{10}$ and $R^{11}$ together are $C_3$-$C_7$alkanediyl which may be interrupted by —O— or $-NR^{12}-$, $R^{12}$ being hydrogen, $C_1$-$C_4$alkyl or $C_2$-$C_4$hydroxyalkyl.

13. The composition according to claim 12, where in formula IV

$Ar^3$ is phenyl or phenyl substituted by chlorine, methyl, isopropyl, dodecyl, methoxy, methylthio, dimethylamino, diethylamino, morpholino or 2-hydroxyethylthio,

$R^7$ and $R^8$ independently of one another are $C_1$-$C_4$alkyl or $R^7$ and $R^8$ together are pentane-1,5-diyl or $C_5$-$C_7$alkenediyl, and

Y is a group —OH, morpholino, piperidino, 4-methylpiperazino or $NR^{10}R^{11}$, $R^{10}$ and $R^{11}$ being $C_1$-$C_4$alkyl or 2-methoxyethyl.

14. The composition according to claim 1, in which component (a) consists of one or more monoethylenically or polyethylenically unsaturated compounds.

15. The composition according to claim 14, in which (c) contains an acrylate or methacrylate of a polyol, of an epoxy resin prepolymer or of a polyurethane containing hydroxyl groups.

16. A process for the polymerization of a material polymerizable by free radical polymerization, by irradiation in the presence of (b) at least one iron compound of the formula I

$$\left[(R^1)\ (R^2Fe^{II})_a\right]^{+a} \cdot \frac{a}{q}\ [X]^{-q} \qquad (I)$$

in which

a is 1 or 2,

q is 1, 2 or 3,

X is halogen, nitrate, sulfate, phosphate, perchlorate or a complex anion $LQ_m$, in which L is a divalent to heptavalent metal or non-metal,

Q is a halogen atom and m is an integer corresponding to the sum of the valency of L and q,

$R^1$ is an unsubstituted or substituted $\pi$-arene, and

$R^2$ is an unsubstituted or substituted cyclopentadienyl anion, characterized by the presence of (c) at least one $\alpha$-cleavage photoinitiator, the sum of (b) and (c) being from 0.05 to 10 %, by weight of the material polymerizable by free radical polymerization and the weight ratio of (b) to (c) being from 6 : 1 to 1 : 4.

17. The process according to claim 18, characterized in that the material is irradiated with light having a wavelength of 200-600 nm.

18. A process for the production of a photographic relief image, characterized in that a composition according to claim 1 is applied to a carrier material, exposed through a photomask according to the process of claim 16, and the unexposed material of the composition is subsequently removed.

19. The process according to claim 18, characterized in that, after removal of the unexposed material, the exposed material is post-cured by a further exposure or by heat treatment.

**Revendications**

1. Composition photopolymérisable contenant :

a) une matière polymérisable par voie radicalaire,

b) au moins un composé du fer répondant à la formule I :

$$\left[(R^1)\ (R^2Fe^{II})_a\right]^{+a} \cdot \frac{a}{q}\ [X]^{-q} \qquad (I)$$

dans laquelle

a est égal à 1 ou à 2,

q est égal à 1, à 2 ou à 3,

X représente un halogène, un radical nitrate, sulfate, phosphate ou perchlorate, ou un radical $[LQ_m]$ dans lequel

L désigne un métal ou un non-métal dont la valence peut aller de 2 à 7,

Q représente un atome d'halogène et

m désigne un nombre entier qui est égal à la somme de q et de la valence de L,

$R^1$ représente un arène $\pi$ substitué ou non et

$R^2$ représente un anion cyclopentadiénure substitué ou non, composition caractérisée en ce qu'elle contient :

c) au moins un photo-amorceur du type des coupeurs $\alpha$, la somme des quantités de (b) et (c) représentant de 0,05 à 10 % en poids de la quantité de (a), et le rapport pondéral de (b) à (c) étant compris entre 6 : 1 et 1 : 4.

2. Composition selon la revendication 1 caractérisée en ce que la somme des quantités de (b) et (c) représente de 0,2 à 5 % en poids de la quantité de (a) et en ce que le rapport pondéral de (b) à (c) est compris entre 2 : 1 et 1 : 2.

3. Composition selon la revendication 1 qui contient, comme composante (b), un composé de formule I dans lequel $R^1$ représente le benzène, un benzène porteur d'un ou de plusieurs substituants pris dans l'ensemble constitué par les halogènes, les alkyles en $C_1$-$C_{12}$, les alcényles en $C_2$-$C_{12}$, les alcynyles en $C_2$-$C_{12}$, les alcoxy en $C_1$-$C_8$, le phénoxy, le cyano, les alkylthio en $C_1$-$C_8$, les alcoxycarbonyles en $C_2$-$C_6$, le phényle, les alcanoyles en $C_2$-$C_5$ et le benzoyle, ou représente un naphtalène ou tétrahydronaphtalène non substitué ou porteur d'un halogène ou d'un alkyle en $C_1$-$C_{12}$.

4. Composition selon la revendication 3 dans laquelle $R^1$ représente le benzène, le toluène, un xylène, le cumène, le mésitylène, le chlorobenzène, un chlorotoluène, l'anisole, un diméthoxybenzène, le biphényle, l'oxyde de diphényle, le dodécylbenzène, un méthylnaphtalène ou le tétrahydronaphtalène.

5. Composition selon la revendication 1 qui contient, comme composante (b), un composé de formule I dans lequel $R^2$ représente un anion cyclopentadiénure qui ne porte pas de substituant ou qui en porte un ou plusieurs pris dans l'ensemble constitué par les alkyles en $C_1$-$C_8$ les alcoxycarbonyles en $C_2$-$C_6$, le cyano, les alcanoyles en $C_2$-$C_5$ et le benzoyle.

6. Composition selon la revendication 5 dans laquelle $R^2$ représente un anion cyclopentadiénure ou méthylcyclopentadiénure.

7. Composition selon la revendication 1 qui contient, comme composante (b), un composé de formule I dans lequel a est égal à 1, q est égal à 1, et X représente un anion complexe $LQ_m$ dans lequel L représente le bore, le phosphore, l'arsenic ou l'antimoine, m est égal à 4 ou à 6 et Q représente le fluor.

8. Composition selon la revendication 1 dans laquelle la composante (b) est l'hexafluorophosphate d'($\eta^6$-isopropylbenzène) ($\eta^6$-cyclopentadiényl) fer (II).

9. Composition selon la revendication 1 dans laquelle la composante (c) est un aroyl-acétal, un dérivé de la benzoïne, un dérivé de l'$\alpha$-hydroxy-acétophénone ou de l'$\alpha$-amino-acétophénone, un ester d'un acide aryl-glyoxylique, un oxyde d'acyl-phosphine, un sel d'halogénonium aromatique ou un sel de sulfonium aromatique.

10. Composition selon la revendication 1 dans laquelle la composante (c) est un composé répondant à la formule II :

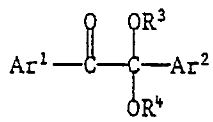

(II)

dans laquelle

$Ar^1$ représente un phényle ou un phényle porteur d'un alkyle en $C_1$-$C_4$ ou d'un halogène,

$Ar^2$ représente l'un des radicaux indiqués pour $Ar^1$ ou représente l'hydrogène, un alkyle en $C_1$-$C_8$ ou un cycloalkyle en $C_5$-$C_8$,

$R^3$ et $R^4$ représentent chacun, indépendamment l'un de l'autre, un alkyle en $C_1$-$C_6$, un alcényle en $C_3$ ou $C_4$, un phénylalkyle en $C_7$-$C_{10}$ ou un alkyle en $C_2$-$C_4$ qui porte un halogène, un alcoxy en $C_1$-$C_4$, un dialkylamino en $C_2$-$C_8$, un morpholino ou un pipéridino, ou encore $R^3$ et $R^4$ forment ensemble un radical alcane-diyle en $C_2$-$C_{12}$ ou un radical butène-2 diyle-1,4.

11. Composition selon la revendication 1 dans laquelle la composante (c) est un composé répondant à la formule III :

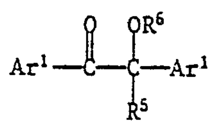

(III)

dans laquelle

$Ar^1$ représente un phényle ou un phényle porteur d'un alkyle en $C_1$-$C_4$ ou d'un halogène,

$R^5$ représente l'hydrogène, un alkyle en $C_1$-$C_4$, un allyle, un benzyle, un hydroxyméthyle ou un ($C_1$-$C_4$-alcoxy)-méthyle, et

$R^6$ représente l'hydrogène, un alkyle en $C_1$-$C_6$, un alcoxyalkyle en $C_3$-$C_8$, un allyle ou un benzyle, ou encore $R^5$ et $R^6$ forment ensemble un radical $-CH_2-O-CH_2-$, $-CH_2-O-C(CH_3)_2-$ ou $-CH_2-O-CH(C_6H_5)-$.

12. Composition selon la revendication 1 dans laquelle la composante (c) est un composé répondant à la formule IV :

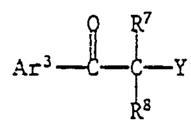

(IV)

dans laquelle

$Ar^3$ représente n phényle ou un phényle porteur d'un ou de plusieurs substituants pris dans l'ensemble constitué par les halogènes, les alkyles en $C_1$-$C_{18}$, les alcényles en $C_3$-$C_{12}$, les alcoxy en $C_1$-$C_{12}$, les alkylthio en $C_1$-$C_{12}$, les alkylamino en $C_1$-$C_{12}$, les dialkylamino en $C_2$-$C_{24}$, les bis-(hydroxyalkyl)-amino en $C_4$-$C_8$, le phénoxy, le phénylthio, le p-tolylthio, l'hydroxy-2 éthylthio, l'allyloxy, l'allylthio, le diallylamino, le bis-(méthoxy-2 éthyl)-amino, le morpholino, le pipéridino et le pyrrolidino,

$R^7$ et $R^8$ représentent chacun, indépendamment l'un de l'autre, un alkyle en $C_1$-$C_8$ ou un alkyle en $C_1$-$C_4$ qui porte un —OH, un alcoxy en $C_1$-$C_4$, un benzyloxy, un —CN, un alcoxycarbonyle à alkyle en $C_1$-$C_8$, un dialkylamino en $C_2$-$C_8$ ou un morpholino, ou $R^7$ et $R^8$ forment ensemble un alcane-diyle en $C_2$-$C_9$, un ($C_1$-$C_4$-alcoxy)-pentane-diyle-1,5, un oxa- ou aza-alcane-diyle en $C_3$-$C_9$ ou un alcène-diyle en $C_5$-$C_9$, et

Y représente un radical $—OR^9$ ou un radical $—NR^{10}R^{11}$ dans lesquels $R^9$ représente l'hydrogène, un alkyle en $C_1$-$C_8$, un alkyle en $C_2$-$C_4$ porteur d'un OH, d'un alkyle en $C_1$-$C_4$ ou d'un —CN, un allyle, un benzyle ou un triméthyl-silyle ou $R^9$ et $R^7$ forment ensemble un radical $—CH_2—O—CH_2—$, $—C(CH_3)_2—O—CH_2—$, $—CH(CH_3)—O—CH_2—$ ou $—CH(C_6H_5)—O—CH_2—$, et $R^{10}$ et $R^{11}$ représentent chacun, indépendamment l'un de l'autre, l'hydrogène, un alkyle en $C_1$-$C_{12}$, un alkyle en $C_2$-$C_4$ porteur d'un —OH, d'un alcoxy en $C_1$-$C_4$, d'un —CN ou d'un alcoxycarbonyle à alkyle en $C_1$-$C_4$, un allyle, un benzyle ou un cyclohexyle ou $R^{10}$ et $R^{11}$ forment ensemble un radical alcane-diyle en $C_3$-$C_7$ qui peut être interrompu par —O— ou par un radical $—NR^{12}—$ dont le symbole $R^{12}$ représente l'hydrogène, un alkyle en $C_1$-$C_4$ ou un hydroxyalkyle en $C_2$-$C_4$.

13. Composition selon la revendication 12 caractérisée en ce que, dans la formule IV,

$Ar^3$ représente un phényle ou un phényle porteur d'un chlore, d'un méthyle, d'un isopropyle, d'un dodécyle, d'un méthoxy, d'un méthylthio, d'un diméthylamino, d'un diéthylamino, d'un morpholino ou d'un hydroxy-2 éthylthio,

$R^7$ et $R^8$ représentent chacun, indépendamment l'un de l'autre, un alkyle en $C_1$-$C_4$, ou $R^7$ et $R^8$ forment ensemble un pentane-diyle-1,5 ou un alcène-diyle en $C_5$-$C_7$, et

Y représente un radical —OH, morpholino, pipéridino, méthyl-4 pipérazino ou $—NR^{10}R^{11}$, les symboles $R^{10}$ et $R^{11}$ représentant chacun un alkyle en $C_1$-$C_4$ ou un méthoxy-2 éthyle.

14. Composition selon la revendication 1 dans laquelle la composante (a) est constituée d'un ou de plusieurs composés contenant une ou plusieurs doubles liaisons éthyléniques.

15. Composition selon la revendication 14 dans laquelle la composante (c) contient un acrylate ou un méthacrylate d'un polyol, d'un prépolymère de résine époxydique ou d'un polyuréthanne contenant des radicaux hydroxy.

16. Procédé pour polymériser, au moyen d'un rayonnement, des matières polymérisables par voie radicalaire, en présence : (b) d'au moins un composé du fer répondant à la formule I :

$$\left[(R^1)\ (R^2Fe^{II})_a\right]^{+a} \cdot \frac{a}{q}\ [X]^{-q} \qquad (I)$$

dans laquelle

a est égal à 1 ou à 2,

q est égal à 1, à 2 ou à 3,

x représente un halogène, un radical nitrate, sulfate, phosphate ou perchlorate, ou un anion complexe $LQ_m$ dans lequel L représente un métal ou un non-métal dont la valence peut aller de 2 à 7,

Q représente un atome d'halogène et m désigne un nombre entier égal à la somme de q et de la valence de L,

$R^1$ représente un arène $\pi$ substitué ou non et

$R^2$ représente un anion cyclopentadiénure substitué ou non, procédé caractérisé par la présence : (c) d'au moins un photo-amorceur du type des coupeurs $\alpha$, la somme des quantités de (b) et de (c) représentant de 0,5 à 10 % en poids de la matière polymérisable par voie radicalaire, et le rapport pondéral de (b) à (c) étant compris entre 6 : 1 et 1 : 4.

17. Procédé selon la revendication 16 caractérisé en ce qu'on irradie avec une lumière d'une longueur d'onde comprise entre 200 et 600 nm.

18. Procédé pour produire photographiquement une image en relief, caractérisé en ce qu'on applique une composition selon la revendication 1 sur une matière support, on l'irradie à travers un photomasque selon le procédé de la revendication 16, puis on élimine de la composition la matière qui n'a pas été touchée par la lumière.

19. Procédé selon la revendication 18 caractérisé en ce qu'après avoir éliminé la matière qui n'a pas été touchée par la lumière on soumet à un durcissement complémentaire la matière touchée par la lumière, cela par une irradiation supplémentaire ou par un traitement à la chaleur.